# EUROPEAN PATENT SPECIFICATION

(11) **EP 2 988 340 B1**
(45) Date of publication and mention of the grant of the patent: **11.10.2017**
(21) Application number: 15180388.9
(22) Date of filing: 10.08.2015
(51) Int. Cl.: H01L 33/50, C09K 11/08, C09K 11/61, C09K 11/77, C09K 11/88, H01L 33/48

(54) **LIGHT EMITTING DIODE PACKAGE AND MANUFACTURING METHOD THEREOF**
LEUCHTDIODENGEHÄUSE UND HERSTELLUNGSVERFAHREN DAFÜR
CONDITIONNEMENT DE DIODE ÉLECTROLUMINESCENTE ET PROCÉDÉ DE FABRICATION CORRESPONDANT

(30) Priority: 18.08.2014 KR 20140106769; 27.08.2014 KR 20140112542; 29.05.2015 KR 20150076499
(43) Date of publication of application: 24.02.2016
(73) Proprietor: Seoul Semiconductor Co., Ltd., Ansan-si, Gyeonggi-do 425-851 (KR)
(72) Inventor: Oh, Kwang Yong, 425-851 Ansan-si, Gyeonggi-do (KR); Byun, Ho Jun, 425-851 Ansan-si, Gyeonggi-do (KR); Kim, Hyuck Jun, 425-851 Ansan-si, Gyeonggi-do (KR); Nam, Ki Bum, 425-851 Ansan-si, Gyeonggi-do (KR); Kim, Su Yeon, 425-851 Ansan-si, Gyeonggi-do (KR)
(74) Representative: Stolmár & Partner Patentanwälte PartG mbB

(56) References cited:
- EP-A1- 2 629 341
- US-A1- 2006 169 998
- US-A1- 2009 020 775

## Description

### BACKGROUND OF THE INVENTION

### FIELD OF THE INVENTION

The present invention relates to a light emitting diode package and a manufacturing method thereof, and more particularly, to a light emitting diode package including a phosphor and a manufacturing method thereof.

### DISCUSSION OF THE BACKGROUND

A light emitting diode (LED) package is referred to as a device which emits predetermined light by recombining minority carriers (electrons or holes) as compound semiconductor having a p-n junction structure of semiconductor. The light emitting diode package may have low power consumption and long lifespan and may be manufactured in a small size.

The light emitting diode package may implement white light using a phosphor which is a wavelength conversion means. That is, the phosphor is disposed on the light emitting diode chip to mix some of primary light of the light emitting diode chip and secondary light of which the wavelength is converted by the phosphor, thereby implementing the white light. The white light emitting diode package having the structure is cheap and is simple in principle and structure. As a result, the white light emitting diode package has been prevalently used.

In detail, the phosphor which absorbs some of blue light as excitation light to emit yellow-green light or yellow light may be coated on a blue light emitting diode chip to obtain the white light. Korean Patent Laid-Open Publication No. 10-2004-0032456 discloses a light emitting diode in which a phosphor using some of blue light as an excitation source to emit yellow-green light or yellow light is coated on a blue light emitting diode chip to emit white light according to blue light emission of the light emitting diode and yellow-green or yellow light emission of the phosphor.

However, the white light emitting diode package based on the foregoing scheme uses the light emission of the yellow phosphor, and therefore has low color rendering due to spectrum deficiency of green and red zones of the emitted light. In particular, when the white light emitting diode package is used as a backlight unit, it is difficult to implement a color close to a natural color due to low color purity after light transmits a color filter.

To solve the above problem, the light emitting diode is manufactured by using the blue light emitting diode chip and the phosphors emitting green light and red light using the blue light as the excitation light. That is, it is possible to implement the white light having high color rendering by mixing of the blue light and the green light and the red light which are excited and emitted by the blue light. When the white light emitting diode is used as the backlight unit, conformity of the white light emitting diode with the color filter is very high and therefore the white light emitting diode may implement an image closer to a natural color. However, the light emitted by the excitation of the phosphor has a full width at half maximum wider than that of the light emitting diode chip. Further, Korean Patent No. 10-0961324 discloses a nitride phosphor, a method of manufacturing the same, and a light emitting device. Reviewing of a light emitting spectrum of the light emitting device including the nitride phosphor, it may be appreciated that the nitride phosphor has a wide full width at half maximum in a red zone. The light having the wide full width at half maximum has reduced color reproduction, and therefore it is difficult to implement the desired color coordinates in the display.

Therefore, to implement the white light having higher color reproduction, there is a need to use a phosphor having a narrower full width at half maximum. To this end, as the phosphor emitting the red light having the narrow full width at half maximum, a fluoride-based phosphor is used. However, the fluoride-based phosphor is vulnerable to moisture and has reduced heat stability, and therefore is problematic in reliability. To apply the light emitting diode package including the phosphor to various products, the high reliability needs to be secured. The reliability of the light emitting diode package ultimately influences the reliability of products to which the light emitting diode package is applied. Therefore, there is a need to develop the light emitting diode package including the phosphor having the high reliability while having the narrow full width at half maximum.

### [Related Art Document]

### [Patent Document]

(Patent Document 1) Korean Patent Laid-Open Publication No. 10-2004-0032456
(Patent Document 2) Korean Patent No. 10-0961324
EP 2 629 341 and US 2006/169998 disclose the features of the pre-amble of the independent claim.

### SUMMARY OF THE INVENTION

An object of the present invention is to provide a light emitting diode package having enhanced reliability and a manufacturing method thereof.

Another object of the present invention is to provide a light emitting diode package including a phosphor which is stabilized against moisture and heat and a manufacturing method thereof.

According to still exemplary embodiment of the present invention, there is provided a light emitting diode package, including: a housing; at least one light emitting diode chip configured to be disposed in the housing; a first phosphor configured to be excited by the at least one light emitting diode chip to emit green light; and a second phosphor configured to be excited by the at least one light emitting diode chip to emit red light, wherein white light is formed by a synthesis of light emitted from the light emitting diode chip, the first phosphor, and the second phosphor, the second phosphor is a phosphor having a chemical formula of A₂MF₆:Mn⁴⁺, the A is one of Li, Na, K, Rb, Ce, and NH₄, and the M is one of Si, Ti, Nb, and Ta, and the Mn⁴⁺ of the second phosphor has a range of the number of moles of 0.02 to 0.035 times about the M.

The white light may have x and y color coordinates forming a point present in the region on a CIE chromaticity diagram, within the range of the number of moles, and the x color coordinate may be 0.25 to 0.32 and the y color coordinate may be 0.22 to 0.32.

A change rate of luminous flux of the white light may be about 5 %, within the range of the number of moles.

A size of a peak wavelength of the green light may be 20 to 35% about the red light.

The first phosphor may be at least one of a BAM-based phosphor and a quantum dot phosphor.

A peak wavelength of the green light of the first phosphor may range from 520 to 570 nm and a peak wavelength of the red light of the second phosphor may range from 610 to 650 nm.

The at least one light emitting diode chip may include at least one of a blue light emitting diode chip and an ultraviolet light emitting diode chip.

The white light may have national television system committee (NTSC) color saturation which is equal to or more than 85%.

The red light emitted from the second phosphor may have a full width at half maximum (FWHM) which is equal to or less than 15 nm.

According to an exemplary embodiment of the present invention, there is provided a light emitting diode package, including: a housing; at least one light emitting diode chip configured to be disposed in the housing; a first phosphor configured to be excited by the at least one light emitting diode chip to emit green light; and a second phosphor and a third phosphor configured to be excited by the at least one light emitting diode chip to emit red light, wherein the second phosphor is a phosphor having a chemical formula of A₂MF₆:Mn⁴⁺, the A is one of Li, Na, K, Ba, Rb, Cs, Mg, Ca, Se, and Zn and the M is one of Ti, Si, Zr, Sn, and Ge, the third phosphor is a nitride-based phosphor and the red light of the second phosphor and the red light of the third phosphor have different peak wavelengths, and the third phosphor has a mass range of 0.1 to 10 wt% with respect to the second phosphor.

The peak wavelength of the green light of the first phosphor may range from 500 to 570 nm, the peak wavelength of the red light of the second phosphor may range from 610 to 650 nm, and the peak wavelength of the red light of the third phosphor may range from 600 to 670 nm.

The third phosphor may include at least one of phosphors which are expressed by a chemical formula of MSiN₂, MSiON₂, and M₂Si₅N₈ and the M may be one of Ca, Sr, Ba, Zn, Mg, and Eu.

Meanwhile, the second phosphor may have a full width at half maximum smaller than that of the third phosphor.

The first phosphor may include at least one selected from a group consisting of a Ba-Al-Mg (BAM)-based phosphor, a quantum dot phosphor, a silicate-based phosphor, a beta-SiAlON-based phosphor, a Garnet-based phosphor, and an LSN-based phosphor.

The at least one light emitting diode chip may include at least one of a blue light emitting diode chip and an ultraviolet light emitting diode chip.

White light may be formed by a synthesis of light emitted from the at least one light emitting diode chip, the first phosphor, the second phosphor, and the third phosphor and the white light may have national television system committee (NTSC) color saturation which is equal to or more than 85%.

The white light may have x and y color coordinates forming a point which is present within a region on a CIE chromaticity diagram, within the mass range and the x color coordinate may be 0.25 to 0.35 and the y color coordinate may be 0.22 to 0.32.

When a height of the housing is 0.6T, the first to third phosphors may have a size sieved by a mesh having a size of 40 to 60 µm and when the height of the housing is 0.4T, the first to third phosphors may have a size sieved by a mesh having a size of 15 to 40 µm.

According to the exemplary embodiments of the present invention, it is possible to provide the light emitting diode package including the phosphor emitting light having the narrow full width at half maximum to improve the color reproduction of the light emitting diode package. Further, it is possible to prevent the deterioration phenomenon that the light emitting characteristics, etc., of the phosphor are reduced under the high temperature and/or high humidity environment to improve the reliability of the phosphor, thereby improving the overall reliability of the light emitting diode package.

According to the exemplary embodiments of the present invention, the reliability of the phosphor included in the light emitting diode package may be enhanced, and as a result, the reliability of the light emitting diode package may be enhanced. Therefore, it is possible to maintain the maintenance of light emitted from the light emitting diode package over a long period of time and minimize the change in CIE color coordinates.

According to the exemplary embodiments of the present invention, the phosphor included in the light emitting diode package may emit the green light and/or the red light having the narrow full width at half maximum, and as a result, the color reproduction of the light emitting diode package may be enhanced.

### BRIEF DESCRIPTION OF THE DRAWINGS

FIG. 1 is a cross-sectional view illustrating a light emitting diode package according to a first exemplary embodiment of the present invention.
FIG. 2 is a cross-sectional view illustrating a light emitting diode package according to a second exemplary embodiment of the present invention.
FIG. 3 is a cross-sectional view illustrating a light emitting diode package according to a third exemplary embodiment of the present invention.
FIG. 4 is a cross-sectional view illustrating a light emitting diode package according to a forth exemplary embodiment of the present invention.
FIG. 5 is a cross-sectional view illustrating a light emitting diode package according to fifth exemplary embodiment of the present invention.
FIG. 6 is a cross-sectional view illustrating a light emitting diode package according to a sixth exemplary embodiment of the present invention.
FIG. 7 is a cross-sectional view illustrating a light emitting diode package according to a seventh exemplary embodiment of the present invention.
FIG. 8 is a cross-sectional view illustrating a light emitting diode package according to an eighth exemplary embodiment of the present invention.
FIG. 9 is a cross-sectional view illustrating a light emitting diode package according to a ninth exemplary embodiment of the present invention.
FIG. 10 is a cross-sectional view illustrating a light emitting diode package according to a tenth exemplary embodiment of the present invention.
FIG. 11 is a flow chart illustrating a manufacturing method of a light emitting diode package according to an exemplary embodiment of the present invention.
FIG. 12 is a diagram illustrating a process of dotting a phosphor at the time of manufacturing the light emitting diode package according to the exemplary embodiment of the present invention.

### DETAILED DESCRIPTION OF THE ILLUSTRATED EMBODIMENTS

Hereinafter, exemplary embodiments of the present invention will be described in detail with reference to the accompanying drawings. It is to be noted that in giving reference numerals to components of each of the accompanying drawings, like reference numerals refer to like elements even though the like components are shown in different drawings. Further, in describing exemplary embodiments of the present invention, well-known functions or constructions will not be described in detail since they may unnecessarily obscure the gist of the present invention. In addition, although exemplary embodiments of the present invention will be described below, the technical spirit of the present invention is not limited thereto, but may be variously modified by those skilled in the art.

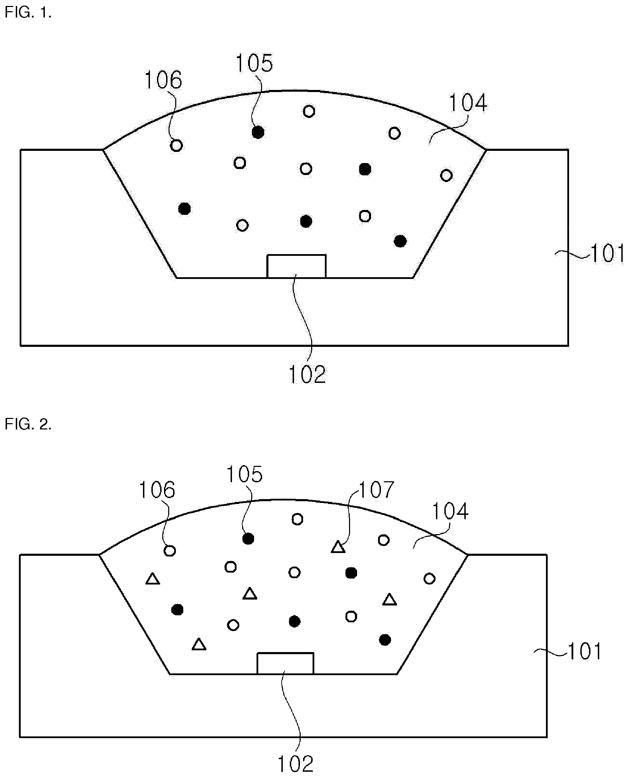

FIG. 1 is a cross-sectional view illustrating a light emitting diode package according to an exemplary embodiment of the present invention. Referring to FIG. 1, the light emitting diode package includes a housing 101, a light emitting diode chip 102, a first phosphor 105, a second phosphor 106, and a molding part 104.

The light emitting diode chip 102, the first phosphor 105, the second phosphor 106, and the molding part 104 may be disposed on the housing 101. The light emitting diode chip 102 may be disposed on a bottom surface of the housing 101. The housing 101 may be provided with lead terminals (not illustrated) for inputting power to the light emitting diode chip 102. The molding part 104 includes the first phosphor and the second phosphor 105 and 106 and may cover the light emitting diode chip 102.

The housing 101 may be made of general plastic (polymer), acrylonitrile butadiene styrene (ABS), liquid crystalline polymer (LCP), polyamide (PA), polyphenylene sulfide (IPS), thermoplastic elastomer, or the like or may also be made of metal or ceramic. When the light emitting diode chip 102 is an ultraviolet light emitting diode chip, the housing 101 may be made of ceramic. When the housing 101 is made of ceramic, the housing 101 including ceramic is not likely to be discolored or spoiled due to ultraviolet rays which are emitted from the ultraviolet light emitting diode chip, and therefore the reliability of the light emitting diode package may be maintained. When the housing 101 is made of metal, the housing 101 may include at least two metal fames which may be insulated from each other. Heat radiation performance of the light emitting diode package may be improved due to the housing 101 including metal. Materials which may form the housing 101 are described above but the housing 101 is not limited thereto, and therefore the housing 101 may be made of various materials.

The housing 101 may include an inclined inner wall to reflect light emitted from the light emitting diode chip 102.

The molding part 104 may be made of materials including at least one of silicone, epoxy, polymethyl methacrylate (PMMA), polyethylene (PE), and polystyrene (PS). The molding part 104 may be made of materials having predetermined hardness if necessary and is not necessarily made of the foregoing materials.

The molding part 104 may be formed by an injection molding process using the foregoing materials and a mixture of the first and second phosphors 105 and 106. Further, the molding part 104 may be manufactured using a separate mold and then is pressed or heat-treated. The molding part 104 may be formed to have various shapes such as a convex lens shape, a flat plate shape (not illustrated), and a shape having predetermined ruggedness on a surface. The light emitting diode package according to the exemplary embodiment of the present invention discloses the molding part 104 having the convex lens shape but the shape of the molding part 104 is not limited thereto.

The light emitting diode chip 102 may be the ultraviolet light emitting diode chip or a blue light emitting diode chip. When the light emitting diode chip 102 is a blue light emitting diode chip, a peak wavelength of emitted light may range from 410 to 490 nm. A full width at half maximum (FWHM) of a peak wavelength of blue light emitted from the light emitting diode chip 102 may be equal to or less than 40 nm. The light emitting diode package according to the exemplary embodiment of the present invention has a shape in which a single light emitting diode chip 102 is disposed, but the number of disposed light emitting diode chips 102 and the disposition shape thereof are not limited thereto.

The first phosphor 105 may be excited by the light emitting diode chip 102 to emit green light. The second phosphor 106 may be excited by the light emitting diode chip 102 to emit red light.

A peak wavelength of green light which is emitted from the first phosphor 105 may range from 520 to 570 nm. The first phosphor 105 may emit the green light having a full width at half maximum which is equal to or less than 35 nm. The first phosphor 105 may include at least one selected from a group consisting of a Ba-Al-Mg (BAM)-based phosphor, a quantum dot phosphor, and a fluoride-based phosphor. The fluoride-based phosphor may be a phosphor having a chemical formula of A₂MF₆ : Mn⁴⁺. In the above chemical formula, A may be one of Li, Na, K, Rb, Ce, and NH₄ and M may be one of Si, Ti, Nb, and Ta. Further, the fluoride-based phosphor may be expressed by the phosphor having a Chemical Formula of AₓM_{y}F_{z} : Mn⁴⁺_{q}. Here, 0 < x ≤ 2.5 and 0 < z ≤ 7.0, in more detail, 1.8 ≤ x ≤ 2.3 and 1.8 ≤ z ≤ 6.9. Further, according to the exemplary embodiment of the present invention, the q may be 0.02 to 0.035 times about the y.

Although a kind of the first phosphor 105 is described above, a kind of the first phosphor 105 according to the exemplary embodiment of the present invention is not limited thereto.

As the full width at half maximum of the green light is narrow, the green light having high color purity may be implemented. When the full width at half maximum is equal to or more than 35 nm, the color purity of the emitted light is low and therefore a color is hard to be reproduced over 85% in a full color reproduction range which is defined as a standard of a national television system committee (NTSC) system adopted as a color television broadcasting system. Therefore, in order to implement NTSC color saturation of 85% or more of white light emitted from the light emitting diode package according to the exemplary embodiment of the present invention, the first phosphor emits green light having a full width at half maximum of 35 nm or less.

The second phosphor 106 may be excited by the light emitting diode chip 102 to emit red light. A peak wavelength of the red light which is emitted from the second phosphor 106 may range from 610 to 650 nm. The second phosphor 106 may include at least one selected from a group consisting of a quantum dot phosphor, a sulfide-based phosphor, and a fluoride-based phosphor. The fluoride-based phosphor may be a phosphor having a chemical formula of A₂MF₆ : Mn⁴⁺. In the above chemical formula, A may be one of Li, Na, K, Rb, Ce, and NH₄ and M may be one of Si, Nb, Ti, and Ta. Further, the fluoride-based phosphor may be expressed by the phosphor having a Chemical Formula of AₓM_{y}F_{z}: Mn⁴⁺_{q}. Here, 0 < x ≤ 2.5 and 0 < z ≤ 7.0, in more detail, 1.8 ≤ x ≤ 2.3 and 1.8 ≤ z ≤ 6.9. Further, according to the exemplary embodiment of the present invention, the q may be 0.02 to 0.035 times about the y.

The second phosphor 106 may emit red light having a narrow full width at half maximum. In detail, in the case of the quantum dot phosphor, the red light having a full width at half maximum of 30 to 40 nm may be emitted, in the case of the sulfide-based phosphor, the red light having a full width at half maximum of 65 nm or less may be emitted, and in the case of the fluoride-based phosphor, the red light having a full width at half maximum of 20 nm or less may be emitted. That is, when the second phosphor 106 is the fluoride-based phosphor, the red light having the narrowest full width at half maximum may be emitted.

Hereinafter, the case in which the first phosphor and/or the second phosphor 105 and 106 is the fluoride-based phosphor will be described in more detail.

As described above, the fluoride-based phosphor may include manganese (Mn) as an active ion. In the fluoride-based phosphor, as the number of moles of manganese is increased, a light quantity of light which is emitted from the phosphor may be increased. However, as the number of moles of manganese is increased, the manganese is oxidized to form manganese oxide, and therefore the reliability of the phosphor is reduced, such that the overall reliability of the light emitting diode package may be reduced.

Therefore, in the chemical formula of A₂MF₆ : Mn⁴⁺, Mn⁴⁺ may have the number of moles within a range of the number of moles of 0.02 to 0.035 times about the M. When Mn⁴⁺ has the number of moles less than 0.02 times about the M, the light emitting diode package according to the exemplary embodiment of the present invention is hard to emit a sufficient light quantity. When Mn⁴⁺ has the number of moles exceeding 0.035 times about the M, it is difficult to secure the reliability of the fluoride-based phosphor, and therefore the reliability of the light emitting diode package according to the exemplary embodiment of the present invention may also be problematic.

Further, when Mn⁴⁺ of the fluoride-based phosphor has the number of moles within the foregoing range of the number of moles, the light emitting diode package according to the exemplary embodiment of the present invention may minimize a change in the light quantity. That is, when the light emitting diode package according to the exemplary embodiment of the present invention has the number of moles of Mn⁴⁺ within the range of the number of moles, the change in light quantity of the emitted white light may be within 5%.

Further, x and y color coordinates forming one point on a CIE chromaticity diagram of the white light may also be minimally changed. In detail, the x color coordinates may be 0.25 to 0.32 and the y color coordinates may be 0.22 to 0.32. In more detail, the x color coordinates may be 0.258 to 0.265 and the y color coordinates may be 0.225 to 0.238.

Further, a change rate of light emitting intensity of the white light according to the exemplary embodiment of the present invention within the range of the number of moles may also be a minimal change rate. In detail, the change rate of the light emitting intensity of the white light may be within 5%.

Hereinafter, the light emitting diode package according to the exemplary embodiment of the present invention including the fluoride-based phosphor will be described with reference to experiment examples.

### [Experimental Example 1]

A first fluoride-based phosphor, a second fluoride-based phosphor, and a third fluoride-based phosphor were prepared. Here, the first fluoride-based phosphor was expressed by a chemical formula of K_{2.230}Si_{0.968}F_{6.870}:Mn⁴⁺0_{.032}. The number of moles of Mn⁴⁺ of the first fluoride-based phosphor is approximately 0.033 times about Si. The number of moles of Mn⁴⁺ of the second fluoride-based phosphor is approximately 0.025 times about Si. The number of moles of Mn⁴⁺ of the third fluoride-based phosphor is approximately 0.020 times about Si. Here, a sum of the number of moles of Si and the number of moles of Mn may maintain 1.

A change in luminous flux, a change in luminous intensity, a change in color coordinates, and the like of the white light of the light emitting diode package including the fluoride-based phosphors, respectively, were measured. In the present experimental example, the fluoride-base phosphors were used as a red phosphor, one of the BAM-based phosphor and the quantum dot phosphor was used as the green phosphor, the BAM-based phosphor used BaMgAl₁₀O₁₇ : Eu, and the quantum dot phosphor used CdSe. Further, the excitation light emitted from the light emitting diode chip used a wavelength range of 450 nm to 460 nm.

As a result of measuring the luminous flux, the white light of the light emitting diode package (hereinafter, first package) including the first fluoride-based phosphor was measured as showing a luminous flux of 75.5 lm, the white light of the light emitting diode package (hereinafter, second package) including the second fluoride-based phosphor was measured as showing a luminous flux of 73.2 lm, and the white light of the light emitting diode package (hereinafter, third package) including the third fluoride-based phosphor was measured as showing a luminous flux of 72.7 lm. That is, it may be appreciated that the luminous flux is changed by approximately 2.5% depending on the change in Mn⁴⁺.

As a result of measuring the luminous intensity, the white light of the first package was measured as showing the luminous intensity of 23223 mcd, the white light of the second package was measured as showing the luminous intensity of 22640 mcd, and the white light of the third package was measured as showing the luminous intensity of 22491 mcd. That is, it may be appreciated that the luminous intensity is changed by approximately 3.2% depending on the change in Mn⁴⁺.

As a result of measuring the change in color coordinates (CIE), the x coordinate of the white light of the first package was measured as 0.264 and the y coordinate thereof was measured as 0.236, the x coordinate of the white light of the second package was measured as 0.264 and the y coordinate thereof was measured as 0.235, and the x coordinate of the white light of the third package was measured as 0.264 and the y coordinate thereof was measured as 0.232. That is, it may be appreciated that the color coordinates are minutely changed depending on the change in Mn⁴⁺.

Further, as a comparison result that the intensity of the peak wavelength (PL intensity) of the red light included in the white light is set to be 1, the intensity of green light of the first package might be measured as 0.34, the intensity of green light of the second package might be measured as 0.27, and the intensity of green light of the third package might be measured as 0.22.

Meanwhile, the reliability of each package for luminous intensity was tested for 1000 hours. A temperature of the packages was 85 °C and a current thereof was 120 mA.

It was shown that as compared with the first intensity, the luminous intensity of the first package is reduced by 9.5%, the luminous intensity of the second package is reduced by 9.6%, and the luminous intensity of the third package is reduced by 8.8%, after 1000 hours. Further, it was shown that for the first CIE coordinates, the x coordinate of the first package is changed by -0.013 and the y coordinate thereof is changed by -0.007, the x coordinate of the second package is changed by -0.014 and the y coordinate thereof is changed by -0.006, and the x coordinate of the third package is changed by -0.014 and the y coordinate thereof is changed by -0.007.

That is, it was shown that the luminous intensities of all of the light emitting diode packages according to the present experimental example are reduced within about 10% and the color coordinates are minutely changed. When the luminous intensity is reduced by 10% or more and the change in the color coordinates was large, the light emitting diode package was hardly used to suit the use purpose. Therefore, the light emitting diode package according to the exemplary embodiment of the present invention may secure high reliability when being used over a long period of time.

Further, the reliability test against the luminous intensity was additionally performed for 1000 hours in the state in which the temperature of the packages is 60°C, relative humidity is 90%, and a current is 120 mA.

In this case, it was shown that as compared with the first intensity, the luminous intensity of the first package is reduced by 4.2%, the luminous intensity of the second package is reduced by 2.6%, and the luminous intensity of the third package is reduced by 3.3%. Further, it was shown that for the first CIE coordinates, the x coordinate of the first package is changed by -0.006 and the y coordinate thereof is changed by -0.006, the x coordinate of the second package is changed by -0.007 and the y coordinate thereof is changed by -0.004, and the x coordinate of the third package is changed by -0.008 and the y coordinate thereof is changed by -0.005. That is, when the light emitting diode package according to the exemplary embodiment of the present invention is exposed to the high humidity environment over a long period of time, the luminous intensity is reduced by 5% or less and the color coordinates are minutely changed, thereby securing the high reliability.

### [Experimental Example 2]

A fourth fluoride-based phosphor, a fifth fluoride-based phosphor, and a sixth fluoride-based phosphor were prepared. Here, the fourth fluoride-based phosphor was expressed by a chemical formula of K_{2.130}Si_{0.970}F_{6.790}:Mn⁴⁺_{0.030}. The number of moles of Mn⁴⁺ of the fourth fluoride-based phosphor is approximately 0.031 times about Si. The number of moles of Mn⁴⁺ of the fifth fluoride-based phosphor is approximately 0.025 times about Si. The number of moles of Mn⁴⁺ of the sixth fluoride-based phosphor is approximately 0.020 times about Si. Here, a sum of the number of moles of Si and the number of moles of Mn may maintain 1.

A change in luminous flux, a change in luminous intensity, a change in color coordinates, and the like of the white light of the light emitting diode package including the fluoride-based phosphors, respectively, were measured. In the present experimental example, the fluoride-base phosphors were used as a red phosphor, one of the BAM-based phosphor and the quantum dot phosphor was used as the green phosphor, the BAM-based phosphor used BaMgAl₁₀O₁₇ : Eu, and the quantum dot phosphor used CdSe. Further, the excitation light emitted from the light emitting diode chip used a wavelength range of 450 nm to 460 nm.

As a result of measuring the luminous flux, the white light of the light emitting diode package (hereinafter, fourth package) including the fourth fluoride-based phosphor was measured as showing a luminous flux of 74.4 lm, the white light of the light emitting diode package (hereinafter, fifth package) including the fifth fluoride-based phosphor was measured as showing a luminous flux of 73.2 lm, and the white light of the light emitting diode package (hereinafter, sixth package) including the sixth fluoride-based phosphor was measured as showing a luminous flux of 72.8 lm. That is, it may be appreciated that the luminous flux is changed by approximately 2.5% depending on the change in Mn⁴⁺.

As a result of measuring the luminous intensity, the white light of the fourth package was measured as showing the luminous intensity of 23540 mcd, the white light of the fifth package was measured as showing the luminous intensity of 22719 mcd, and the white light of the sixth package was measured as showing the luminous intensity of 23360 mcd. That is, it may be appreciated that the luminous intensity is changed by approximately 3.5% depending on the change in Mn⁴⁺.

As a result of measuring the change in color coordinates (CIE), the x coordinate of the white light of the fourth package was measured as 0.264 and the y coordinate thereof was measured as 0.237, the x coordinate of the white light of the fifth package was measured as 0.264 and the y coordinate thereof was measured as 0.235, and the x coordinate of the white light of the sixth package was measured as 0.264 and the y coordinate thereof was measured as 0.234. That is, it may be appreciated that the color coordinates are almost constant independent of the change in Mn⁴⁺.

Further, as a comparison result that the intensity of the peak wavelength (PL intensity) of the red light included in the white light is set to be 1, the intensity of green light of the fourth package might be measured as 0.32, the intensity of green light of the fifth package might be measured as 0.27, and the intensity of green light of the sixth package might be measured as 0.22.

Meanwhile, the reliability of each package was tested for 1000 hours of the luminous intensity. A temperature of the packages was 85 °C and a current thereof was 120 mA.

It was shown that as compared with the first intensity, the luminous intensity of the fourth package is reduced by 8.5%, the luminous intensity of the fifth package is reduced by 9.4%, and the luminous intensity of the sixth package is reduced by 9.7%, after 1000 hours. Further, it was shown that for the first CIE coordinates, the x coordinate of the fourth package is changed by -0.013 and the y coordinate thereof is changed by -0.007, the x coordinate of the fifth package is changed by -0.013 and the y coordinate thereof is changed by -0.007, and the x coordinate of the sixth package is changed by -0.012 and the y coordinate thereof is changed by -0.007.

That is, it was shown that the luminous intensities of all of the light emitting diode packages according to the present experimental example are reduced by less than 10% and the color coordinates are minutely changed. When the luminous intensity of the light emitting diode package is reduced by 10% or more and the change in the color coordinates was large, the light emitting diode package was hardly used to suit the use purpose. Therefore, the light emitting diode package according to the exemplary embodiment of the present invention may secure relatively higher reliability than the related art even when being used over a long period of time.

Further, the reliability test against the luminous intensity was additionally performed for 1000 hours in the state in which the temperature of the packages is 60 °C, relative humidity is 90%, and a current is 120 mA.

In this case, it was shown that as compared with the first intensity, the luminous intensity of the fourth package is reduced by 2.1%, the luminous intensity of the fifth package is reduced by 1.9%, and the luminous intensity of the sixth package is reduced by 2.2%. Further, it was shown that for the first CIE coordinates, the x coordinate of the fourth package is changed by -0.007 and the y coordinate thereof is changed by -0.004, the x coordinate of the fifth package is changed by -0.007 and the y coordinate thereof is changed by -0.004, and the x coordinate of the sixth package is changed by -0.006 and the y coordinate thereof is changed by -0.005. That is, when the light emitting diode package according to the exemplary embodiment of the present invention is exposed to the high humidity environment over a long period of time, the luminous intensity is reduced by 3% or less and the color coordinates are minutely changed, thereby securing the relatively higher reliability as compared with the related art.

According to the exemplary embodiment of the present invention, the fluoride-based phosphor includes the active ion of manganese (Mn) having a predetermined range to secure the high reliability while having the sufficient light quantity. Therefore, the light emitting diode package according to the exemplary embodiment of the present invention may also secure the sufficient light quantity and the high reliability.

FIG. 2 is a cross-sectional view illustrating a light emitting diode package according to a first exemplary embodiment of the present invention. Referring to FIG. 2, the light emitting diode package includes a housing 101, a light emitting diode chip 102, a first phosphor 105, a second phosphor 106, a third phosphor 107, and a molding part 104.

The light emitting diode chip 102, the first phosphor 105, the second phosphor 106, the third phosphor 107, and the molding part 104 may be disposed on the housing 101. The light emitting diode chip 102 may be disposed on a bottom surface of the housing 101 and the housing 101 may be provided with lead terminals (not illustrated) through which power is input to the light emitting diode chip 102. The molding part 104 includes the first, second, and third phosphors 105, 106, and 107 and may cover the light emitting diode chip 102.

The molding part 104 may be made of a material having high hardness. In detail, the hardness of the molding part 104 may have a measurement numerical value of 69 to 71 when being measured by shore hardness and an indentor type may be a D type. To obtain the high hardness, the molding part 104 may be made of materials including at least one of silicone, epoxy, polymethyl methacrylate (PMMA), polyethylene (PE), and polystyrene (PS).

The molding part 104 may be formed by an injection molding process using the foregoing materials and a mixture of the first, second, and third phosphors 105, 106, and 107. Further, the molding part 104 may be manufactured using a separate mold and then is pressed or heat-treated. The molding part 104 may be formed to have various shapes such as a convex lens shape, a flat plate shape (not illustrated), and a shape having predetermined ruggedness on a surface. The light emitting diode package according to the exemplary embodiment of the present invention has the molding part 104 having the convex lens shape but the shape of the molding part 104 is not limited thereto.

The first phosphor 105 may be excited by the light emitting diode chip 102 to emit green light. The second phosphor 106 and the third phosphor 107 may be excited by the light emitting diode chip 102 to emit red light.

A peak wavelength of green light which is emitted from the first phosphor 105 may range from 500 to 570 nm. The first phosphor 105 may emit the green light having a full width at half maximum which is equal to or less than 35 nm. The first phosphor 105 may include at least one selected from a group consisting of a Ba-Al-Mg (BAM)-based phosphor, a quantum dot phosphor, a silicate-based phosphor, a beta-SiAlON-based phosphor, a Garnet-based phosphor, an LSN-based phosphor, and a fluoride-based phosphor. The fluoride-based phosphor may be a phosphor having a chemical formula of A₂MF₆ : Mn⁴⁺. In the above Chemical Formula, the A may be one of Li, Na, K, Ba, Rb, Cs, Mg, Ca, Se, and Zn and the M may be Ti, Si, Zr, Sn, and Ge. Although a kind of the first phosphor 105 is described above, a kind of the first phosphor 105 according to the exemplary embodiment of the present invention is not limited thereto.

The second phosphor 106 may be excited by the light emitting diode chip 102 to emit red light. A peak wavelength of the red light which is emitted from the second phosphor 106 may range from 610 to 650 nm. The second phosphor 106 may include at least one selected from a group consisting of a quantum dot phosphor, a sulfide-based phosphor, and a fluoride-based phosphor. The fluoride-based phosphor may be a phosphor having a chemical formula of A₂MF₆ : Mn⁴⁺. In the above Chemical Formula, the A may be one of Li, Na, K, Ba, Rb, Cs, Mg, Ca, Se, and Zn and the M may be one of Ti, Si, Zr, Sn, and Ge.

The third phosphor 107 may be excited by the light emitting diode chip 102 to emit red light. The peak wavelength of the red light emitted from the third phosphor 107 is different from that of red light emitted from the second phosphor 106. In detail, the peak wavelength of the red light emitted from the third phosphor 107 may range from 600 to 670 nm. The third phosphor 107 may be a nitride-based phosphor. The nitride-based phosphor may include at least one of phosphors which are expressed by a chemical formula of MSiN₂, MSiON₂, and M₂Si₅N₈ and the M may be one of Ca, Sr, Ba, Zn, Mg, and Eu. The third phosphor 107 may have a mass range of 0.1 to 10 wt% with respect to the second phosphor 106. In more detail, the third phosphor 107 may have a mass range of 1.48 to 10 wt% with respect to the second phosphor 106.

According to the exemplary embodiment of the present invention, when a mass percentage of the third phosphor 107 to the second phosphor 106 is equal to or larger than at least 0.1 wt%, the reliability of the phosphors may be enhanced. Further, when a mass percentage of the third phosphor 107 to the second phosphor 106 is equal to or larger than 1.48 wt%, the reliability of the phosphors may be more enhanced. Further, when the mass percentage of the third phosphor 107 to the second phosphor 106 exceeds 10 wt%, the full width at half maximum of the red light emitted from the phosphors 106 and 107 may be increased to a predetermined value or more and therefore the color reproduction of the light emitting diode package may be reduced. As a result, according to the exemplary embodiment of the present invention, the full width at half maximum of the second phosphor may range from about 1 to 10 nm and the full width at half maximum of the third phosphor may range from about 70 to 100 nm.

According to the exemplary embodiment of the present invention, the light emitting diode package includes the second phosphor 106 and the third phosphor 107 which emit the red light. When the third phosphor 107 is the nitride-based phosphor, the third phosphor 107 is strong against heat and/or moisture and therefore the overall reliability of the phosphors including the same may be enhanced. Therefore, the light emitting diode package according to the exemplary embodiment of the present invention may maintain the CIE color coordinates within a predetermined range even after the light emitting diode package is used over a long period of time.

Hereinafter, the light emitting diode package according to the exemplary embodiment of the present invention including the second and third phosphors will be described with reference to experimental examples.

### [Experimental Example 3]

Two sample light emitting diode packages are prepared. A first sample is a red phosphor and includes only the second phosphor 106 and a second sample is a red phosphor and includes the second and third phosphors 106 and 107. Except for the kind of included red phosphors, all other conditions of the first and second samples are the same.

Here, the second phosphor 106 is a fluoride-based phosphor which has Chemical Formula of K₂SiF₆:Mn⁴⁺. The third phosphor 107 is a nitride-based phosphor which has a chemical formula of CaSiN_{2:}Eu²⁺. The third phosphor 107 has a mass of 2.96 wt% with respect to the second phosphor 106. Each of the samples includes the green phosphor. As the green phosphor, the beta-SiAlON-based phosphor is used and may be expressed by a chemical formula of β-SiAlON:Eu²⁺. Further, to excite the phosphors included in each of the samples, the excited light emitted from the light emitting diode chip has a wavelength range of 440 nm to 460 nm.

A reliability test was performed on each of the samples having the foregoing conditions for 1000 hours. A temperature of the samples was 85 °C and an input current was 20mA.

For a first CIE coordinate after the reliability test is completed, it was shown that an x color coordinate of the first sample is changed by - 0.011 and a y color coordinate is changed by + 0.002. On the other hand, it was shown that an x color coordinate of the second sample is changed by -0.007 and a y color coordinate is changed by + 0.002.

That is, it may be appreciated that the light emitting diode package according to the exemplary embodiment of the present invention includes two kinds of red phosphors and therefore exhibits excellent reliability under high temperature environment as compared with the case in which light emitting diode package includes only one fluoride-based phosphor.

### [Experimental Example 4]

The reliability test was performed for 1000 hours by changing temperature and humidity conditions, while having the same samples as the foregoing sample. A temperature of the samples was 60 °C, relative humidity was 90%, and the input current was 20mA.

For the first CIE coordinates after the reliability test is completed, it was shown that the x color coordinate of the first sample is changed by - 0.007 and the y color coordinate is changed by +0.006. On the other hand, it was shown that the x color coordinate of the second sample is changed by -0.003 and the y color coordinate is changed by +0.006.

That is, it may be appreciated that the light emitting diode package according to the exemplary embodiment of the present invention includes two kinds of red phosphors and therefore exhibits excellent reliability under high humidity environment as compared with the case in which light emitting diode package includes only one fluoride-based phosphor.

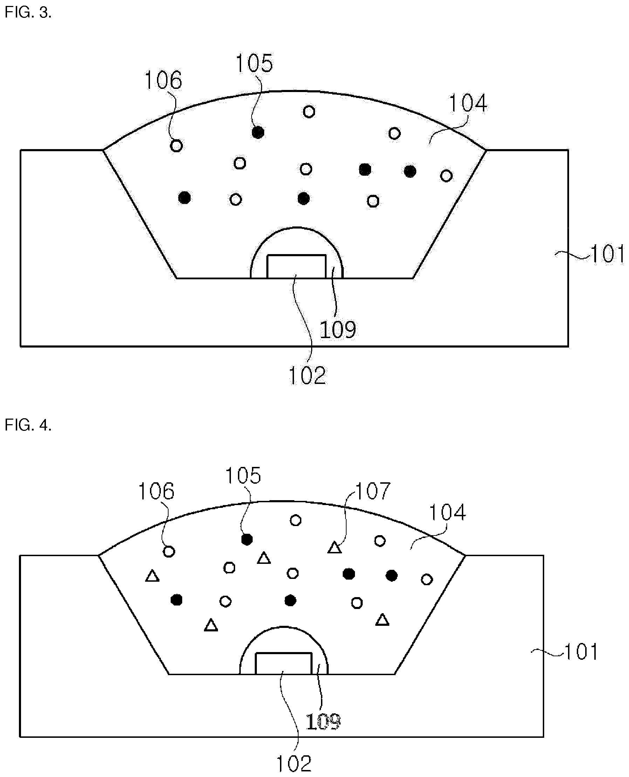

FIG. 3 is a cross-sectional view illustrating a light emitting diode package according to a third embodiment of the present invention. Referring to FIG. 3, the light emitting diode package includes the housing 101, the light emitting diode chip 102, the molding part 104, the first phosphor 105, the second phosphor 106, and a buffer part 109. The light emitting diode package according to another exemplary embodiment of the present invention is similar to the light emitting diode package according to the exemplary embodiment of the present invention except for the buffer part 109 and therefore the overlapping description thereof will be omitted.

The buffer part 109 may be disposed between the light emitting diode chip 102 and the molding part 104. The buffer part may be made of materials including at least one of silicone, epoxy, polymethyl methacrylate (PMMA), polyethylene (PE), and polystyrene (PS). The hardness of the buffer part 109 may be smaller than that of the molding part 104. A thermal stress of the molding part 104 due to heat generated from the light emitting diode chip 102 may be prevented by using the buffer part 109. The case in which the buffer part 109 according to the exemplary embodiment of the present invention is disposed around the light emitting diode chip 102 is disclosed, but the buffer part 109 may also be disposed in a wide region to contact both of the left wall and the right wall of the housing 101.

FIG. 4 is a cross-sectional view illustrating a light emitting diode package according to a forth exemplary embodiment of the present invention. Referring to FIG. 4, the light emitting diode package includes the housing 101, the light emitting diode chip 102, the molding part 104, the first phosphor 105, the second phosphor 106, the third phosphor 107, and the buffer part 109. The light emitting diode package according to another exemplary embodiment of the present invention is similar to the light emitting diode package according to the exemplary embodiment of the present invention except for the buffer part 109 and therefore the overlapping description thereof will be omitted.

The buffer part 109 may be disposed between the light emitting diode chip 102 and the molding part 104. The buffer part may be made of materials including at least one of silicone, epoxy, polymethyl methacrylate (PMMA), polyethylene (PE), and polystyrene (PS). The hardness of the buffer part 109 may have a measurement numerical value of 59 to 61 when being measured by the shore hardness and the indentor type may be an A type. The hardness of the buffer part 109 may be smaller than that of the molding part 104. A thermal stress of the molding part 104 due to heat generated from the light emitting diode chip 102 may be prevented by using the buffer part 109. The case in which the buffer part 109 according to the exemplary embodiment of the present invention is disposed around the light emitting diode chip 102 is disclosed, but the buffer part 109 may also be disposed in a wide region to contact both of the left wall and the right wall of the housing 101.

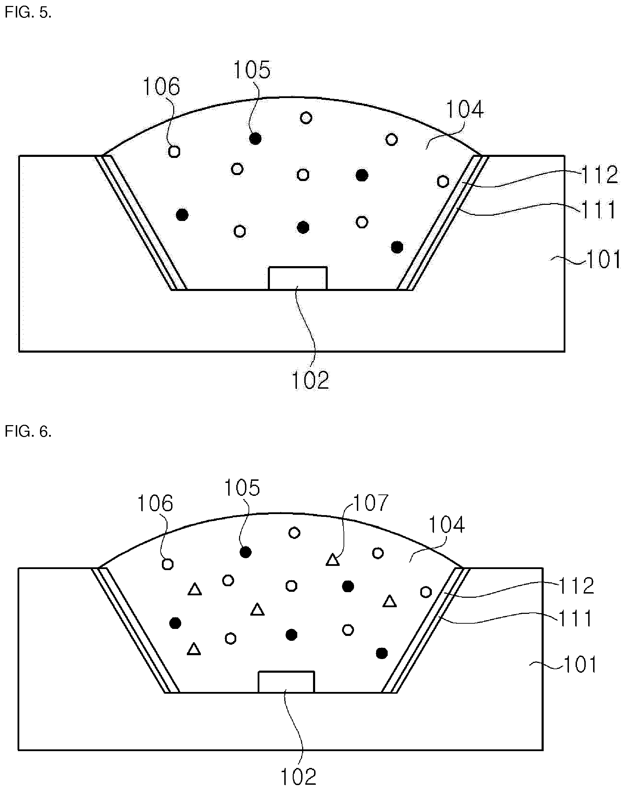

FIG. 5 is a cross-sectional view illustrating a light emitting diode package according to a fifth exemplary embodiment of the present invention. Referring to FIG. 5, the light emitting diode package includes the housing 101, the light emitting diode chip 102, the molding part 104, the first phosphor 105, the second phosphor 106, a reflector 111, and a barrier reflector 112. The light emitting diode package according to still another exemplary embodiment of the present invention is substantially similar to the light emitting diode package according to the exemplary embodiment of the present invention except for the reflector 111 and the barrier reflector 112 and therefore the overlapping description thereof will be omitted.

The reflector 111 may be disposed on a side, while being spaced apart from the light emitting diode chip 102. The reflector 111 may maximize the reflection of light emitted from the light emitting diode chip 102 and the first and second phosphors 105 and 106 to increase luminous efficiency. The reflector 111 may be formed of any one of a reflection coating film and a reflection coating material layer. The reflector 111 may be made of at least one of inorganic materials, organic materials, metal materials, and metal oxides which have excellent heat resistance and light resistance. For example, the reflector 111 may be made of metals or metal oxides which have high reflectance, such as aluminum (Al), silver (Ag), gold (Au), and titanium dioxide (TiO₂) The reflector 111 may be formed by depositing or coating the metals or the metal oxides on the housing 101 and may also be formed by printing metal ink. Further, the reflector 111 may also be formed by bonding a reflection film or a reflection sheet on the housing 101.

The barrier reflector 112 may cover the reflector 111. The barrier reflector 112 may prevent the deterioration of the reflector 111, and the like, due to the heat emitted from the light emitting diode chip 102. The barrier reflector 112 may be made of the inorganic materials or the metal materials which have the high light resistance and reflectance.

FIG. 6 is a cross-sectional view illustrating a light emitting diode package according to a sixth exemplary embodiment of the present invention. Referring to FIG. 6, the light emitting diode package includes the housing 101, the light emitting diode chip 102, the molding part 104, the first phosphor 105, the second phosphor 106, the third phosphor 107, a reflector 111, and a barrier reflector 112. The light emitting diode package according to still another exemplary embodiment of the present invention is substantially similar to the light emitting diode package according to the exemplary embodiment of the present invention except for the reflector 111 and the barrier reflector 112 and therefore the overlapping description thereof will be omitted.

The reflector 111 may be disposed on a side, while being spaced apart from the light emitting diode chip 102. The reflector 111 may maximize the reflection of light emitted from the light emitting diode chip 102 and the first, second, and third phosphors 105, 106, and 107 to increase luminous efficiency. The reflector 111 may be formed of any one of a reflection coating film and a reflection coating material layer. The reflector 111 may be made of at least one of inorganic materials, organic materials, metal materials, and metal oxides which have excellent heat resistance and light resistance. For example, the reflector 111 may be made of metals or metal oxides which have high reflectance, such as aluminum (Al), silver (Ag), gold (Au), and titanium oxide (TiO₂). The reflector 111 may be formed by depositing or coating the metals or the metal oxides on the housing 101 and may also be formed by printing metal ink. Further, the reflector 111 may also be formed by bonding a reflection film or a reflection sheet on the housing 101.

The barrier reflector 112 may cover the reflector 111. The barrier reflector 112 may prevent the deterioration of the reflector 111, and the like, due to the heat emitted from the light emitting diode chip 102. The barrier reflector 112 may be made of the inorganic materials or the metal materials which have the high light resistance and reflectance.

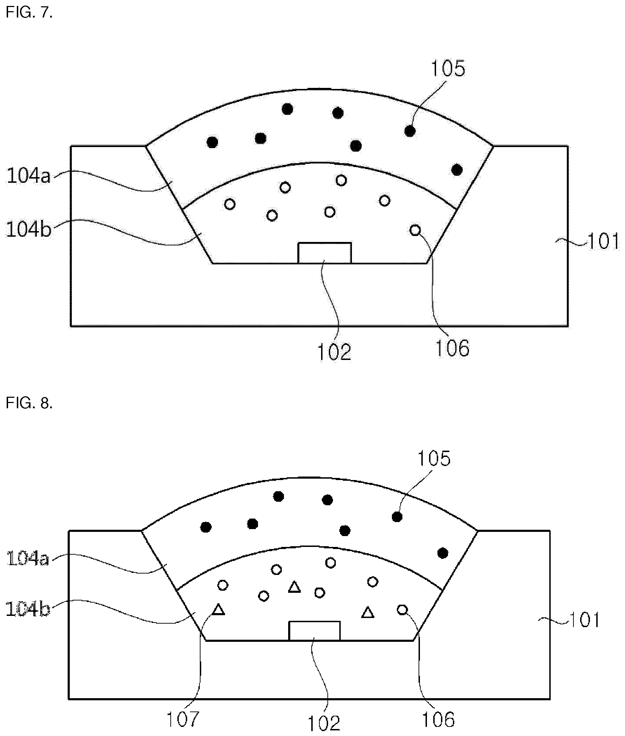

FIG. 7 is a cross-sectional view illustrating a light emitting diode package according to a seventh exemplary embodiment of the present invention. Referring to FIG. 7, the light emitting diode package may include the housing 101, the light emitting diode chip 102, the molding part 104, the first phosphor 105, and the second phosphor 106, in which the molding part 104 may further include a first molding part 104b and a second molding part 104a. The light emitting diode package according to still another exemplary embodiment of the present invention is substantially similar to the light emitting diode package according to the exemplary embodiment of the present invention except for the first molding part 104b and the second molding part 104a and therefore the overlapping description thereof will be omitted.

The first molding part 104b may cover the light emitting diode chip 102. The second molding part 104a may cover the first molding part 104b. The first molding part 104b may be made of a material having the same hardness as the second molding part 104a or may be made of a material having different hardness. The hardness of the first molding part 104b may be lower than that of the second molding part 104a. In this case, it is possible to alleviate the thermal stress due to the light emitting diode chip 102, like the buffer part 109 according to the exemplary embodiment of the present invention as described above.

The first molding part 104b may include the second phosphor 106 which emits the red light. The second molding part 104a may include the first phosphor 105 which emits the green light. The phosphors which emit light having a long wavelength are disposed at a lower portion and the phosphors which emit light having a short wavelength are disposed at an upper portion, and thus the green light emitted from the first phosphor 105 may be prevented from being lost by being again absorbed into the second phosphor 106.

FIG. 8 is a cross-sectional view illustrating a light emitting diode package according to an eighth exemplary embodiment of the present invention. Referring to FIG. 8, the light emitting diode package may include the housing 101, the light emitting diode chip 102, the molding part 104, the first phosphor 105, the second phosphor 106, and the third phosphor 107, in which the molding part 104 may include a first molding part 104b and a second molding part 104a. The light emitting diode package according to still another exemplary embodiment of the present invention is substantially similar to the light emitting diode package according to the exemplary embodiment of the present invention except for the first molding part 104b and the second molding part 104a and therefore the overlapping description thereof will be omitted.

The first molding part 104b may cover the light emitting diode chip 102. The second molding part 104a may cover the first molding part 104b. The first molding part 104b may be made of a material having the same hardness as the second molding part 104a or may be made of a material having different hardness. The hardness of the first molding part 104b may be lower than that of the second molding part 104a. In this case, it is possible to alleviate the thermal stress due to the light emitting diode chip 102, like the buffer part 109 according to the exemplary embodiment of the present invention as described above.

The first molding part 104b may include the second phosphor 106 and the third phosphor 107 which emit the red light. The second molding part 104a may include the first phosphor 105 which emits the green light. The phosphors which emit a long wavelength are disposed at a lower portion and the phosphors which emit a short wavelength are disposed at an upper portion, and thus the green light emitted from the first phosphor 105 may be prevented from being lost by being again absorbed into the second phosphor 106 and the third phosphor 107.

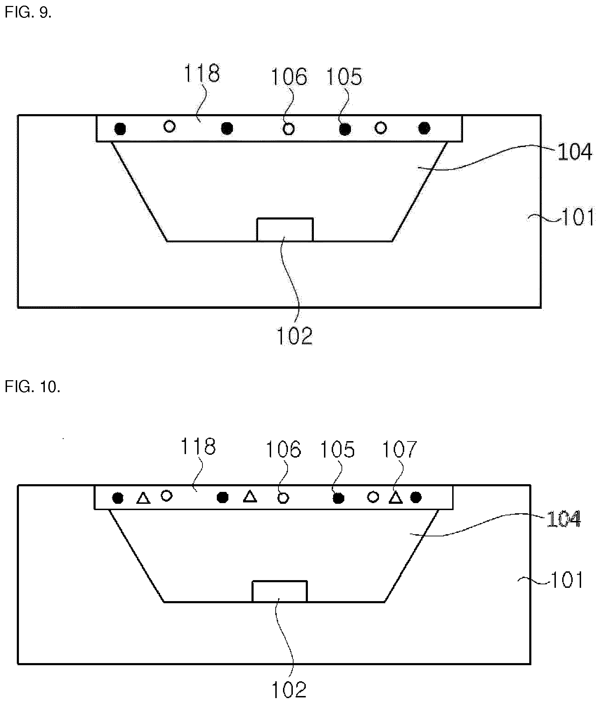

FIG. 9 is a cross-sectional view illustrating a light emitting diode package according to a ninth exemplary embodiment of the present invention. Referring to FIG. 9, the light emitting diode package includes the housing 101, the light emitting diode chip 102, the molding part 104, the first phosphor 105, the second phosphor 106, and a phosphor plate 118. The light emitting diode package according to still another exemplary embodiment of the present invention is similar to the light emitting diode package according to the exemplary embodiment of the present invention except for the phosphor plate 118 and therefore the overlapping description thereof will be omitted.

The phosphor plate 118 is disposed on the molding part 104 while being spaced apart from the light emitting diode chip 102 and may include the first and second phosphors 105 and 106. The phosphor plate 118 may be made of the same material as the molding part 104 according to the exemplary embodiment of the present invention or a material having high hardness.

Since the first and second phosphors 105 and 106 are disposed while being spaced from the light emitting diode chip 102, it is possible to reduce the damage due to the heat or light of the first and second phosphors 105 and 106 and the phosphor plate 118. Therefore, the reliability of the first and second phosphors 105 and 106 may be improved.

Instead of the molding part 104, an empty space may be formed between the phosphor plate 118 and the light emitting diode chip 102.

According to the exemplary embodiments of the present invention, it is possible to provide the light emitting diode package including the phosphor emitting light having the narrow full width at half maximum to improve the color reproduction of the light emitting diode package. Further, it is possible to prevent the deterioration phenomenon that the light emitting characteristics, etc., of the phosphor are reduced under the high temperature and/or high humidity environment to improve the reliability of the phosphor, thereby improving the overall reliability of the light emitting diode package.

FIG. 10 is a cross-sectional view illustrating a light emitting diode package according to a tenth exemplary embodiment of the present invention. Referring to FIG. 10, the light emitting diode package includes the housing 101, the light emitting diode chip 102, the molding part 104, the first phosphor 105, the second phosphor 106, the third phosphor 107, and the phosphor plate 118. The light emitting diode package according to still another exemplary embodiment of the present invention is similar to the light emitting diode package according to the exemplary embodiment of the present invention except for the phosphor plate 118 and therefore the overlapping description thereof will be omitted.

The phosphor plate 118 is disposed on the molding part 104 while being spaced apart from the light emitting diode chip 102 and may include the first, second, and third phosphors 105, 106, and 107. The phosphor plate 118 may be made of the same material as the molding part 104 according to the exemplary embodiment of the present invention or a material having high hardness.

Since the first, second, and third phosphors 105, 106, and 107 are disposed while being spaced apart from the light emitting diode chip 102, it is possible to reduce the damage due to the heat or light of the first, second, and third phosphors 105, 106, and 107 and the phosphor plate 118. Therefore, the reliability of the first, second, and third phosphors 105, 106, and 107 may be improved.

Instead of the molding part 104, an empty space may be formed between the phosphor plate 118 and the light emitting diode chip 102.

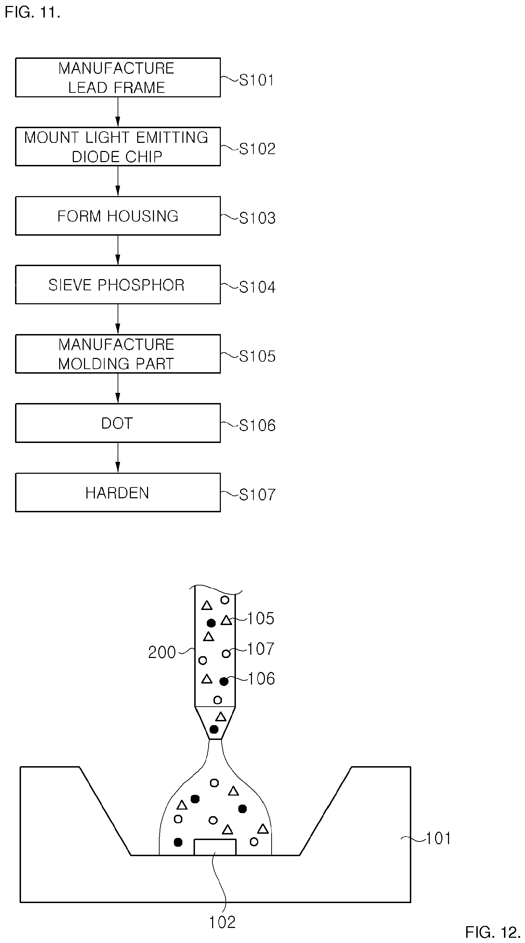

FIG. 11 is a flow chart illustrating a manufacturing method of a light emitting diode package according to an exemplary embodiment of the present invention and FIG. 12 is a diagram illustrating a process of dotting phosphors 105, 106, and 107 at the time of manufacturing the light emitting diode package according to the exemplary embodiment of the present invention.

The manufacturing method of the light emitting diode package according to the exemplary embodiment of the present invention will be described with reference to FIG. 12, along with a flow chart of FIG. 11.

To manufacture the light emitting diode package according to the exemplary embodiment of the present invention, the lead frame is manufactured (S101), in which the lead frame forms the conductive pattern on the surface on which the light emitting diode chip 102 is mounted. Further, a shape of the lead frame may be manufactured by being variously changed depending on a kind of light emitting diode package.

The so manufactured lead frame is mounted with the light emitting diode chip 102 (S102). The light emitting diode chip 102 may be mounted on the conductive pattern which is formed on the lead frame. The housing 101 is packaged in the state in which the light emitting diode chip 102 is mounted on the lead frame (S103). The housing 101 may be formed to enclose a part or the whole of the lead frame to support the lead frame and as illustrated in FIG. 12, a position at which the light emitting diode chip 102 is mounted may be provided with a cavity.

As described above, the molding part 104 needs to be manufactured before the molding part 104 is formed in the formed housing 101. As described in the exemplary embodiments of the present invention, the molding part 104 may include at least one kind of phosphors 105, 106, and 107. The light emitted from the light emitting diode chip 102 is excited by the phosphors 105, 106, and 107, which has a grain shape having a predetermined size as illustrated in FIG. 12. The phosphors 105, 106, and 107 having a granular particle shape are formed in the light emitting diode package in the state in which they are mixed in the liquid-phase molding part 104.

When the molding part 104 is formed on the upper portion of the light emitting diode chip 102, the molding part 104 may be formed by various processes, but it will be described that the molding part is formed by the dotting process in the manufacturing method of a light emitting diode package according to the exemplary embodiment of the present invention.

The dotting process is a process of applying the liquid-phase molding part 104 using a needle 200 when the liquid-phase molding part 104 is applied to the upper portion of the light emitting diode chip 102. As a result, an inlet of the needle 200 may vary depending on the size of the light emitting diode package. As described above, when the liquid-phase molding part 104 in which the phosphors 105, 106, and 107 having the granular particle shape are mixed are dotted on the light emitting diode package using the needle 200, if the particles of the phosphors 105, 106, and 107 are larger than the inlet of the needle 200, the inlet of the needle 200 may stop.

For this reason, the particle size of the phosphors 105, 106, and 107 needs to be limited depending on the size of the light emitting diode package. According to the exemplary embodiment of the present invention, the phosphors 105, 106, and 107 may be sieved depending on the required size prior to manufacturing the liquid-phase molding part 104.

The sieving of the phosphors 105, 106, and 107 is a process of filtering the phosphors 105, 106, and 107 to allow the size of the phosphors 105, 106, and 107 to be smaller than a predetermined size. According to the exemplary embodiment of the present invention, when the entire height of the housing 101 is 0.6T mm, the phosphors 105, 106, and 107 having a mesh size of 40 µm to 50 µm may be used. Further, when the entire height of the housing 101 is 0.4T, the phosphors 105, 106, and 107 having a mesh size of 25 µm to 35 µm may be used.

As described above, the phosphors 105, 106, and 107 are sieved to set the size of the particle of the phosphors 105, 106, and 107, and then the sieved phosphors 105, 106, and 107 are mixed in the liquid-phase molding part 104 to manufacture the liquid-phase molding part 104 (S105). The molding part 104 may include various materials like resin, hardener, additives, etc., in addition to the phosphors 105, 106, and 107 to form the molding part 104. For example, the molding part 104 may include at least one of silicone, epoxy, polymethyl methacrylate (PMMA), polyethylene (PE), and polystyrene (PS) in addition to the phosphors 105, 106, and 107.

Further, the molding part 104 may include at least one kind of phosphors 105, 106, and 107 mixed therein and therefore as described in another exemplary embodiment of the present invention, the molding part may include the first to third phosphors 105, 106, and 107. The first phosphor 105 may have the peak wavelength of the green light ranging from 500 to 570 nm and the second phosphor 106 may have the peak wavelength of the red light ranging from 610 to 650 nm. Further, the third phosphor 107 may have the peak wavelength of the red light ranging from 600 to 670 nm.

As described above, as the particle size of the phosphor is limited, the particle size of the phosphor may be constant at a predetermined size. As a result, the light emitted from the light emitting diode chip may be excited by the phosphor having the uniform particle size, and thus a color coordinate distribution of light is reduced, such that the light emitted from the light emitting diode package according to the exemplary embodiment of the present invention may show the more uniform quality.

Further, when the liquid-phase molding part 104 is dotted on the housing 101 using the needle 200, the problem that the inlet of the needle 200 is closed by the particle size of the phosphors 105, 106, and 107 may not be caused.

As described above, the manufactured liquid-phase molding part 104 is applied to the housing 101 of the light emitting diode package by the dotting method using the needle 200 (S106). In this case, as described in other exemplary embodiments of the present invention, the molding part 104 may be formed to have various shapes.

The liquid-phase molding part 104 is hardened in the state in which the liquid-phase molding part 104 is applied to the light emitting diode package by the dotting process (S107). The so manufactured light emitting diode package is manufactured by the post-process like a test process, etc.

## Claims

1. A light emitting diode package, comprising:
- a housing; (101) - at least one light emitting diode chip (102) configured to be disposed in the housing;
- a first phosphor (105) configured to be excited by the at least one light emitting diode chip to emit green light, wherein a peak wavelength of the green light of the first phosphor ranges from 520 to 570 nm; and
- a second phosphor (106) configured to be excited by the at least one light emitting diode chip to emit red light, wherein a peak wavelength of the red light of the second phosphor ranges from 610 to 650 nm,
wherein white light is formed by a synthesis of light emitted from the light emitting diode chip, the first phosphor, and the second phosphor,
the second phosphor is a phosphor having a chemical formula of A₂MF₆:Mn⁴⁺, the A is one of Li, Na, K, Rb, Ce, and NH₄, and the M is one of Si, Ti, Nb, and Ta, and **characterized in that** the Mn⁴⁺ of the second phosphor has a range of the number of moles of 0.02 to 0.035 times of M.

2. The light emitting diode package of claim 1, wherein the white light has x and y color coordinates forming a point present in a region on a CIE chromaticity diagram, within the range of the number of moles, and
the x color coordinate is 0.25 to 0.32 and the y color coordinate is 0.22 to 0.32.

3. The light emitting diode package of claim 1, wherein a change rate of luminous flux of the white light is about 5 %, within the range of the number of moles.

4. The light emitting diode package of claim 1, wherein a peak wavelength of the green light is 20 to 35% of the peak wavelength of the red light.

5. The light emitting diode package of claim 1, wherein the first phosphor is at least one of a BAM-based phosphor and a quantum dot phosphor.

6. The light emitting diode package of claim 1, wherein the at least one light emitting diode chip includes at least one of a blue light emitting diode chip and an ultraviolet light emitting diode chip.

7. The light emitting diode package of claim 1, wherein the white light has national television system committee (NTSC) color saturation which is equal to or more than 85%.

8. The light emitting diode package of claim 1, wherein the red light emitted from the second phosphor has a full width at half maximum (FWHM) which is equal to or less than 15 nm.

## Patentansprüche

1. Lichtemissionsdiodenpaket, umfassend:
- ein Gehäuse (101);
- mindestens einen lichtemittierenden Diodenchip (102), der derart eingerichtet ist, dass er in dem Gehäuse angeordnet ist;
- Einen ersten Leuchtstoff (105), der derart eingerichtet ist, dass er durch den mindestens einen lichtemittierenden Diodenchip angeregt wird, um grünes Licht zu emittieren, wobei eine Spitzenwellenlänge des grünen Lichts des ersten Leuchtstoffs von 520 bis 570 nm reicht; und
- einen zweiten Leuchtstoff (106), der derart eingerichtet ist, dass er von dem mindestens einen lichtemittierenden Diodenchip angeregt wird, um rotes Licht zu emittieren, wobei eine Spitzenwellenlänge des roten Lichts des zweiten Leuchtstoffs im Bereich von 610 bis 650 nm liegt,
wobei weißes Licht durch eine Synthese von Licht gebildet wird, das von dem lichtemittierenden Diodenchip, des ersten Leuchtstoffes und des zweiten Leuchtstoffes emittiert wird,
der zweite Leuchtstoff ist ein Leuchtstoff der chemischen Formel A₂MF₆:Mn⁴⁺, wobei A ausgewählt ist aus Li, Na, K, Rb, Ce und NH₄ und M ist ausgewählt aus Si, Ti, Nb und Ta, und
**dadurch gekennzeichnet, dass** Mn⁴⁺ des zweiten Leuchtstoffes einen Bereich der Molzahl des 0,02 bis 0,035 fachen von M aufweist.

2. Lichtemissionsdiodenpaket nach Anspruch 1, wobei das weiße Licht x und y Farbkoordinaten aufweist, die einen in einem Bereich auf einem CIE-Chromatizitätsdiagramm vorhandenen Punkt innerhalb des Bereichs der Molzahlen bilden, und wobei
die x-Farbkoordinate 0,25 bis 0,32 und die y-Farbkoordinate 0,22 bis 0,32 beträgt.

3. Lichtemissionsdiodenpaket nach Anspruch 1, wobei eine Änderungsrate des Lichtstroms des weißen Lichts etwa 5% innerhalb des Bereichs der Molzahl beträgt.

4. Lichtemissionsdiodenpaket nach Anspruch 1, wobei eine Spitzenwellenlänge des grünen Lichts 20 bis 35% der Spitzenwellenlänge des roten Lichts beträgt.

5. Lichtemissionsdiodenpaket nach Anspruch 1, wobei der erste Leuchtstoff mindestens ein BAM-basierter Leuchtstoff und ein Quantenpunkt-Leuchtstoff ist.

6. Lichtemissionsdiodenpaket nach Anspruch 1, wobei der mindestens eine lichtemittierende Diodenchip mindestens einen blauen lichtemittierenden Diodenchip und einen ultravioletten lichtemittierenden Diodenchip aufweist.

7. Lichtemissionsdiodenpaket nach Anspruch 1, wobei das weiße Licht eine der nationalen Fernsehsystemkommission (NTSC) entsprechende Farbsättigung aufweist, die gleich oder mehr als 85% ist.

8. Lichtemissionsdiodenpaket nach Anspruch 1, wobei das von dem zweiten Leuchtstoff emittierte rote Licht eine volle Breite bei halbem Maximum (FWHM) aufweist, das gleich oder kleiner als 15 nm ist.

## Revendications

1. Un boîtier de diode électroluminescente, comprenant:
- un boîtier (101);
- au moins une puce de diode électroluminescente (102) configurée pour être disposée dans le boîtier;
- un premier phosphore (105) configuré pour être excité par l'au moins une puce de diode électroluminescente pour émettre de la lumière verte, dans lequel une longueur d'onde de crête de la lumière verte du premier phosphore est dans la plage de 520 à 570 nm; et
- un deuxième phosphore (106) configuré pour être excité par l'au moins une puce de diode électroluminescente pour émettre de la lumière rouge, dans lequel une longueur d'onde de crête de la lumière rouge du deuxième phosphore est dans la plage de 610 à 650 nm,
dans lequel lumière blanche est constituée par une synthèse de la lumière émise par le puce de diode électroluminescente, le premier phosphore, et le deuxième phosphore,
le deuxième phosphore est un phosphore ayant une formule chimique de A₂MF₆:Mn⁴⁺, le A étant un parmi Li, Na, K, Rb, Ce, et NH₄, et le M étant un parmi Si, Ti, Nb, et Ta, et
**caractérisé en ce que**
le Mn⁴⁺ du deuxième phosphore a une gamme du nombre de moles de 0.02 à 0.035 fois M.

2. Le boîtier de diode électroluminescente selon la revendication 1, dans lequel la lumière blanche a des coordonnées de couleur x et y formant un point présent dans une région sur un diagramme de chromaticité CIE, dans la gamme du nombre de moles, et
la coordonnée de couleur x est 0.25 à 0.32 et la coordonnée de couleur y est 0.22 à 0.32.

3. Le boîtier de diode électroluminescente selon la revendication 1, dans lequel un taux de variation de flux lumineux de la lumière blanche est d'environ 5 %, dans la gamme du nombre de moles.

4. Le boîtier de diode électroluminescente selon la revendication 1, dans lequel une longueur d'onde de crête de la lumière verte est de 20 à 35% de la longueur d'onde de crête de la lumière rouge.

5. Le boîtier de diode électroluminescente selon la revendication 1, dans lequel le premier phosphore est au moins un d'un phosphore à base de BAM et d'un phosphore à point quantique.

6. Le boîtier de diode électroluminescente selon la revendication 1, dans lequel l'au moins une puce de diode électroluminescente comprend au moins une parmi une puce de diode électroluminescente bleu et une puce de diode électroluminescente ultraviolette.

7. Le boîtier de diode électroluminescente selon la revendication 1, dans lequel la lumière blanche a une saturation de couleur de comité de système de télévision nationale (NTSC) qui est égal ou supérieure à 85%.

8. Le boîtier de diode électroluminescente selon la revendication 1, dans lequel la lumière rouge émise par le deuxième phosphore présente une largeur complète à mi-hauteur (FWHM) qui est égal ou inférieure à 15 nm.
